# EUROPEAN PATENT APPLICATION

(11) **EP 4 481 808 A1**
(43) Date of publication of application: **25.12.2024**
(21) Application number: 24182248.5
(22) Date of filing: 14.06.2024
(51) Int. Cl.: H01L 23/495

(54) **DUAL LEADFRAME SEMICONDUCTOR DEVICE AND METHOD THEREFOR**

(30) Priority: 20.06.2023 US 202318337622
(71) Applicant: NXP B.V., 5656 AG Eindhoven (NL)
(72) Inventor: Cheng, Hsin-En, 5656AG Eindhoven (NL); Oberndorff, Pascal, 5656AG Eindhoven (NL); Li, Yu Chen, 5656AG Eindhoven (NL); Li, Hsiu Chun, 5656AG Eindhoven (NL)
(74) Representative: Hardingham, Christopher Mark

(57) **Abstract**

A method of manufacturing a semiconductor device is provided. The method includes attaching a first semiconductor die to a first die pad of a first leadframe and attaching a second semiconductor die to a second die pad of a second leadframe. The first leadframe is attached to the second leadframe by way of a non-conductive adhesive. A first plurality of leads of the first leadframe are interleaved with leads of a second plurality of leads of the second leadframe. The first and second semiconductor die and portions of the first and second leadframes are encapsulated with an encapsulant.

## Description

### Background

### Field

This disclosure relates generally to semiconductor devices, and more specifically, to semiconductor device with dual leadframes and method of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. For some features and applications, the configuration of the semiconductor device packages may be susceptible to lower reliability, lower performance, and higher product or system costs. Accordingly, significant challenges exist in accommodating these features and applications while minimizing the impact on semiconductor devices' reliability, performance, and costs.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 through FIG. 7 illustrate, in simplified cross-sectional views, an example semiconductor device with dual leadframes at stages of manufacture in accordance with an embodiment.
FIG. 8 and FIG. 9 illustrate, in simplified cross-sectional views, alternative example semiconductor devices dual leadframes at a stage of manufacture in accordance with an embodiment.
FIG. 10 illustrates, in a simplified plan view, an example portion of a semiconductor device with dual leadframes at a stage of manufacture in accordance with an embodiment.

### Detailed Description

Generally, there is provided, a semiconductor device having dual leadframes. The semiconductor device includes a first semiconductor die mounted on a die pad of a first package leadframe having a first plurality of conductive leads and a second semiconductor die mounted on a die pad of a second package leadframe having a second plurality of conductive leads. The first package leadframe and the second package leadframe are joined together by way of an adhesive. Portions of the first and second package leadframes along with respective first and second semiconductor die are encapsulated with an encapsulant. Exposed portions of the first plurality of conductive leads and the second plurality of conductive leads are trimmed and formed in a desire shape. The resulting exposed lead pattern around the perimeter of the semiconductor device is an alternating or interleaved-like arrangement where the exposed leads of the first plurality of conductive leads are interleaved with the exposed leads of the second plurality of conductive leads. By forming the semiconductor device with an interleaved lead pattern in this manner, a cost effective, higher lead density with a finer lead pitch is achieved through joining two lower cost leadframes having coarser lead pitches.

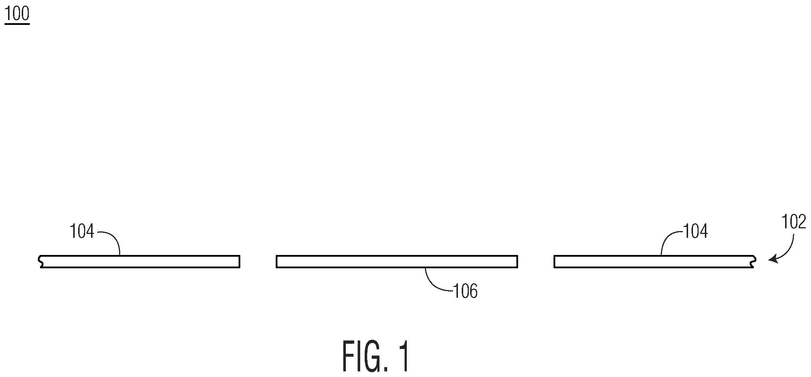

FIG. 1 through FIG. 7 illustrate, in simplified cross-sectional views, an example semiconductor device 100 having dual leadframes at stages of manufacture in accordance with an embodiment.

FIG. 1 illustrates, in a simplified cross-sectional view, the example semiconductor device 100 at a stage of manufacture in accordance with an embodiment. At this stage, a first leadframe 102 of the semiconductor device 100 includes a plurality of conductive leads 104 and a conductive die pad 106. In this embodiment, the plurality of leads 104 is substantially coplanar with the die pad 106. In some embodiments, the die pad 106 may be upset (e.g., located above the plane of the leads) or downset (e.g., located below the plane of the leads). The plurality of leads 104 of the leadframe 102 is arranged to substantially surround the die pad 106. The die pad 106 of the leadframe 102 is configured for attachment of one or more semiconductor die. The plurality of leads 104 is configured and arranged to couple electrical signals between external (e.g., printed circuit board) locations of a mounted semiconductor device and internal locations such as bond pads of a semiconductor die attached to the die pad 106, for example.

The leadframe 102 may be formed from suitable electrically conductive materials, such as copper, silver, nickel, aluminum, iron, or alloys thereof, for example. The conductive metal may be bare, partially plated, or plated with another metal or an alloy such as iron/nickel alloy, silver, gold, copper, or the like. The term "conductive," as used herein, generally refers to electrical conductivity unless otherwise specified. Leadframe features such as tie bars and dam bars are not shown for illustration purposes.

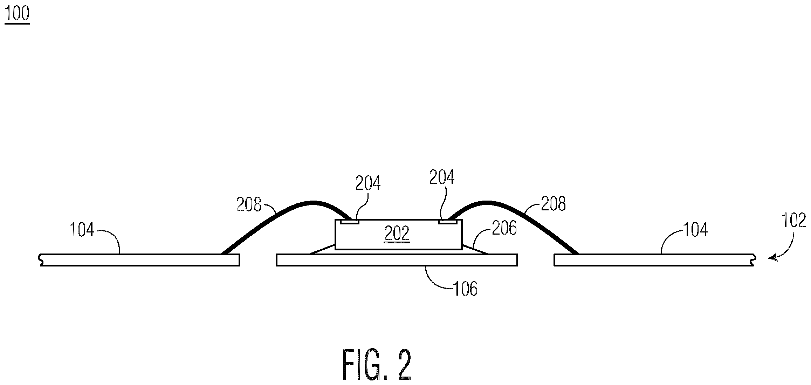

FIG. 2 illustrates, in a simplified cross-sectional view, the example semiconductor device 100 at a subsequent stage of manufacture in accordance with an embodiment. At this stage, a semiconductor die 202 is attached to the die pad 106 and wire bonded to leads 104 of the leadframe 102. In this embodiment, the semiconductor die 202 is attached to the die pad 106 by way of a die attach material 206. The die attach material 206 may be an epoxy resin based adhesive material, solder alloy, or the like for example. In some embodiments, the semiconductor die 202 may be attached to the die pad 106 by way of eutectic bonding. Bond pads 204 of the semiconductor die 202 are configured for connection to respective leadframe leads 104 by way of the bond wires 208, for example. A first end of the bond wire 208 is attached at a respective bond pad 204 and a second end of the bond wire 208 is attached at a corresponding lead 104. The bond wires 208 may be formed from a suitable metal material such as copper, silver, gold, aluminum, or alloys thereof, for example.

The semiconductor die 202 has an active side (e.g., major side having circuitry, bond pads) and a backside (e.g., major side opposite of the active side). The semiconductor die 202 includes the bond pads 204 located at the active side of the semiconductor die. In this embodiment, semiconductor die 202 is configured in an active-side-up orientation with the backside affixed to the die pad 106. The semiconductor die 202 may be formed from any suitable semiconductor material, such as silicon, germanium, gallium arsenide, gallium nitride, and the like. The semiconductor die 202 may further include any digital circuits, analog circuits, RF circuits, power circuits, memory, processor, the like, and combinations thereof at the active side.

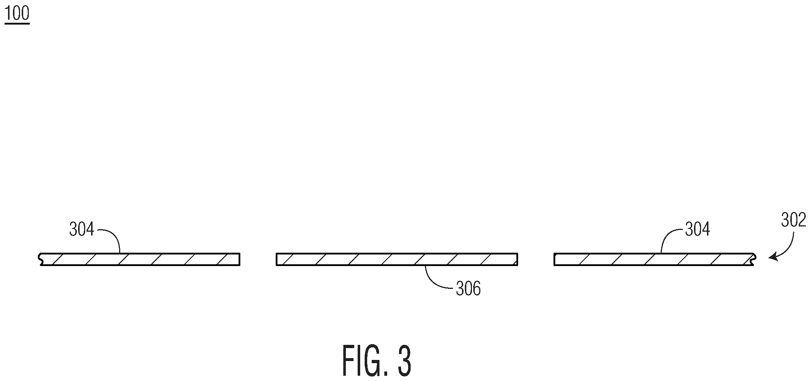

FIG. 3 illustrates, in a simplified cross-sectional view, the example semiconductor device 100 at a stage of manufacture in accordance with an embodiment. At this stage, a second leadframe 302 of the semiconductor device 100 includes a plurality of conductive leads 304 and a conductive die pad 306. For illustration purposes, the leadframe 302 is depicted with a fill-pattern (e.g., diagonal hatch) different from the leadframe 102. In this embodiment, the plurality of leads 304 is substantially coplanar with the die pad 306. In some embodiments, the die pad 306 may be upset or downset relative to the plurality of leads 304. The plurality of leads 304 of the leadframe 302 is arranged to substantially surround the die pad 306. The die pad 306 of the leadframe 302 is configured for attachment of one or more semiconductor die. The plurality of leads 304 is configured and arranged to couple electrical signals between external (e.g., printed circuit board) locations of a mounted semiconductor device and internal locations such as bond pads of a semiconductor die attached to the die pad 306, for example.

The leadframe 302 may be formed from suitable electrically conductive materials, such as copper, silver, nickel, aluminum, iron, or alloys thereof, for example. The conductive metal may be bare, partially plated, or plated with another metal or an alloy such as iron/nickel alloy, silver, gold, copper, or the like. Leadframe features such as tie bars and dam bars are not shown for illustration purposes.

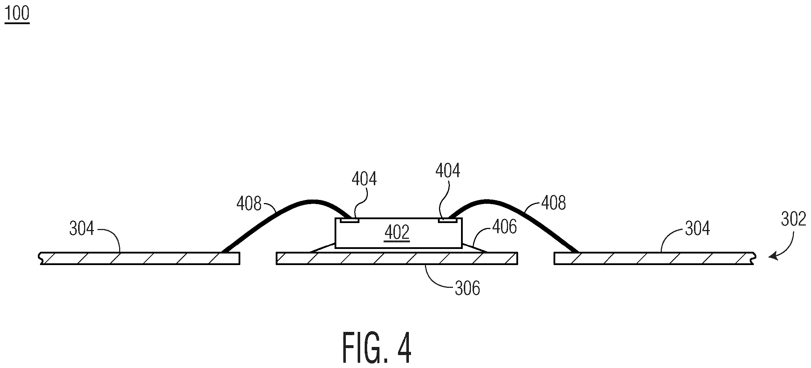

FIG. 4 illustrates, in a simplified cross-sectional view, the example semiconductor device 100 at a subsequent stage of manufacture in accordance with an embodiment. At this stage, a semiconductor die 402 is attached to the die pad 306 and wire bonded to leads 304 of the leadframe 302. In this embodiment, the semiconductor die 402 is attached to the die pad 306 by way of a die attach material 406. The die attach material 406 may be similar to the die attach material 206 (e.g., epoxy resin-based adhesive, solder alloy) or may be a different die attach material. In some embodiments, the semiconductor die 402 may be attached to the die pad 306 by way of eutectic bonding. Bond pads 404 of the semiconductor die 402 are configured for connection to respective leadframe leads 304 by way of the bond wires 408, for example. A first end of the bond wire 408 is attached at a respective bond pad 404 and a second end of the bond wire 408 is attached at a corresponding lead 304. The bond wires 408 may be formed from a suitable metal material such as copper, silver, gold, aluminum, or alloys thereof, for example.

The semiconductor die 402 has an active side (e.g., major side having circuitry, bond pads) and a backside (e.g., major side opposite of the active side). The semiconductor die 402 includes the bond pads 404 located at the active side of the semiconductor die. In this embodiment, semiconductor die 402 is configured in an active-side-up orientation with the backside affixed to the die pad 306. The semiconductor die 402 may be formed from any suitable semiconductor material, such as silicon, germanium, gallium arsenide, gallium nitride, and the like. The semiconductor die 402 may further include any digital circuits, analog circuits, RF circuits, power circuits, memory, processor, the like, and combinations thereof at the active side.

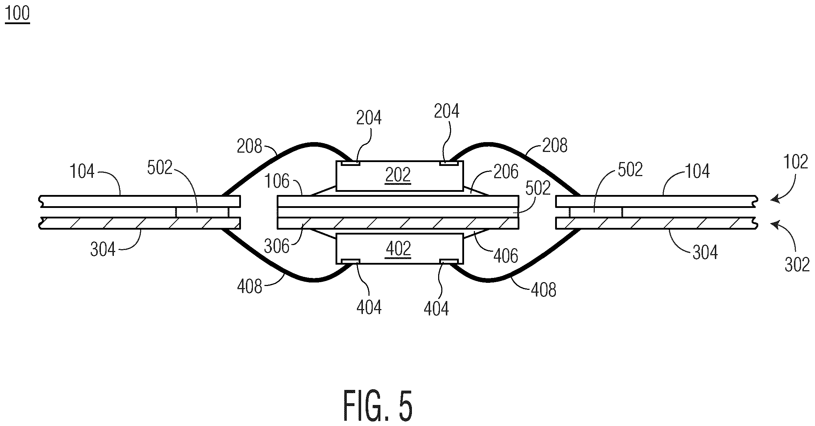

FIG. 5 illustrates, in a simplified cross-sectional view, the example semiconductor device 100 at a subsequent stage of manufacture in accordance with an embodiment. At this stage, the first leadframe 102 populated with mounted semiconductor die 202 and the second leadframe 302 populated with mounted semiconductor die 402 are joined together. In this embodiment, the populated leadframe 302 is flipped such that a backside of the leadframe 302 and the backside of the populated leadframe 102 are attached to one another by way of a non-conductive adhesive material 502. The non-conductive adhesive material 502 may be in the form of a double-sided tape or die attach film (DAF), for example. The populated leadframes 102 and 302 are joined together in a stacked arrangement such that leads 104 are interleaved with leads 304 when viewed from a top-down or bottom-up perspective, for example.

In this embodiment, a portion of the non-conductive adhesive material 502 may be disposed between proximal regions of the leads 104 and 304 and between the die pads 106 and 306. In some embodiments, the leadframes 102 and 302 may be formed with the die pads 106 and 306 configured in an upset (e.g., raised above the plane of the leads) arrangement such that a gap is formed between the die pads 106 and 306 when joined together. The gap between the die pads 106 and 306 allows for additional mold compound flow at a subsequent stage of manufacture, for example.

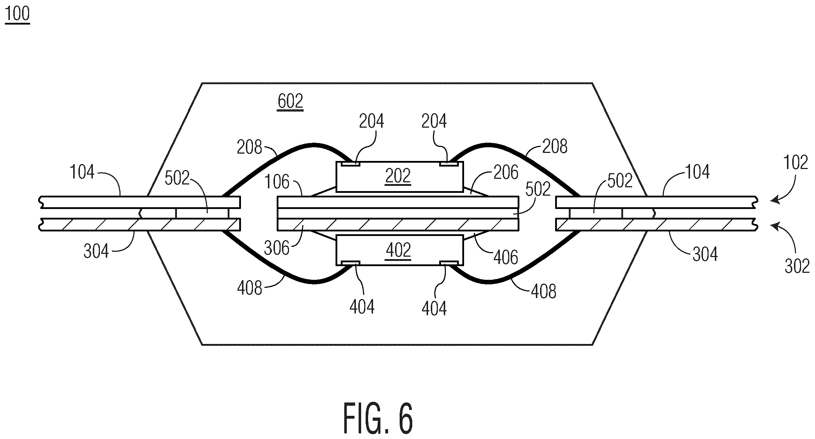

FIG. 6 illustrates, in a simplified cross-sectional view, the example semiconductor device 100 at a subsequent stage of manufacture in accordance with an embodiment. At this stage, portions of the leadframes 102 and 302 joined together along with respective semiconductor die 202 and 402 are encapsulated with an encapsulant 602. In this embodiment, proximal regions of the leads 104 and 304, the die pads 106 and 306, and mounted semiconductor die 202 and 402 are over-molded with the encapsulant 602 by way of a molding process. Accordingly, the adhesive material 502 located between the proximal regions of the leads 104 and 304 and between the die pads 106 and 306 is encapsulated during the molding process. The encapsulant 602 may be an epoxy molding compound (EMC) dispensed during an injection or transfer molding encapsulation operation, for example.

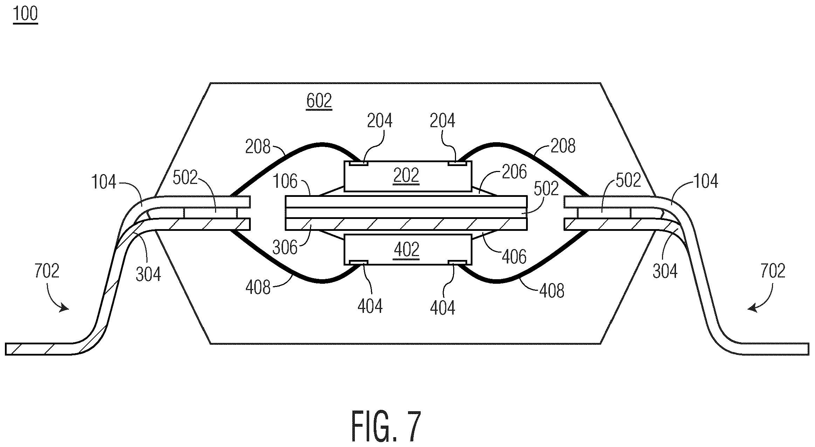

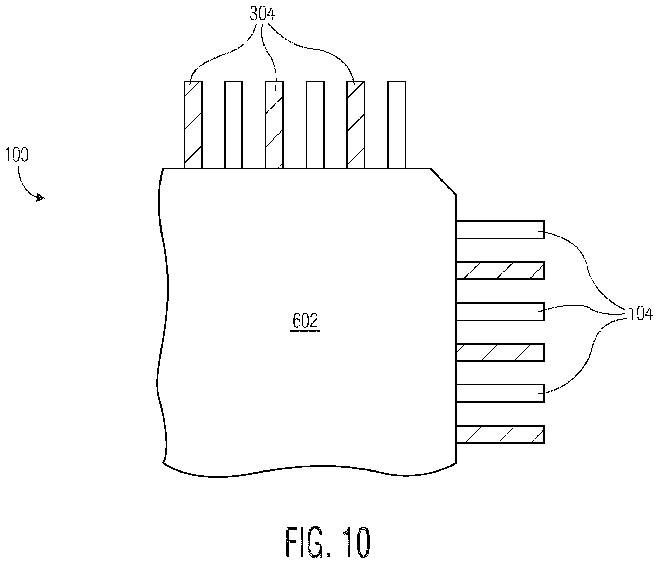

FIG. 7 illustrates, in a simplified cross-sectional view, the example semiconductor device 100 at a subsequent stage of manufacture in accordance with an embodiment. At this stage, exposed portions of the leads 104 and 304 of the semiconductor device 100 are trimmed and formed. The semiconductor device 100 is subjected to a trim and form operation. During the trim and form operation, the leads 104 and 304 are singulated from respective leadframes 102 and 302 and mechanically shaped. In this embodiment, the leads 104 and 304 are configured in a gullwing shape and electrically isolated from one another. Distal regions 702 of the leads 104 and 304 are mechanically formed (e.g., bent) to provide a substantially flat surface suitable for solder attachment to a printed circuit board, for example. In other embodiments, the leads 104 and 304 may be mechanically formed in other suitable shapes (e.g., J-lead) and configurations. In this embodiment, the resulting lead pattern is an alternating or interleaved-like arrangement. A plan view of a portion of the example semiconductor device 100 including an example lead pattern arrangement is depicted in FIG. 10.

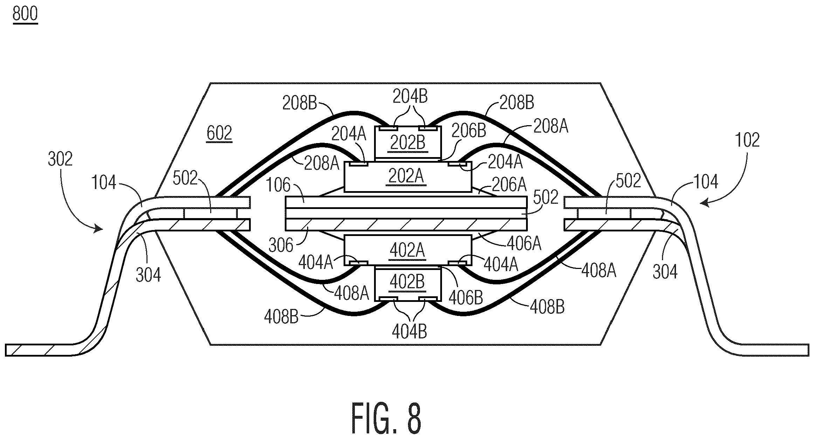

FIG. 8 illustrates, in a simplified cross-sectional view, an alternative example semiconductor device 800 at a stage of manufacture in accordance with an embodiment. In this embodiment, stacked semiconductor die 202A-B and 402A-B are attached to the respective die pads 106 and 306, wire bonded to respective leads 104 and 304 and encapsulated with the encapsulant 602.

As an alternative to the semiconductor die 202 attached to the die pad 106 of the leadframe 102 by way of the die attach material 206 and wire bonded to leadframe leads 104 by way of the bond wires 208 depicted in FIG. 2, the semiconductor die 202A is attached to the die pad 106 of the leadframe 102 by way of die attach material 206A and the semiconductor die 202B is attached to the semiconductor die 202A by way of a second die attach material 206B. Bond pads 204A and 204B of respective semiconductor die 202A and 202B are connected to respective leadframe leads 104 by way of bond wires 208A and 208B. In some embodiments, the semiconductor die 202A and 202B may be configured in a side-by-side arrangement as an alternative to the stacked semiconductor die 202A-B. In some embodiments, at least one of the semiconductor die 202A and 202B may be configured in a flip-chip arrangement.

Likewise, as an alternative to the semiconductor die 402 attached to the die pad 306 of the leadframe 302 by way of the die attach material 406 and wire bonded to leadframe leads 304 by way of the bond wires 408 depicted in FIG. 4, the semiconductor die 402A is attached to the die pad 306 of the leadframe 302 by way of die attach material 406A and the semiconductor die 402B is attached to the semiconductor die 402A by way of a second die attach material 406B. Bond pads 404A and 404B of respective semiconductor die 402A and 402B are connected to respective leadframe leads 304 by way of bond wires 408A and 408B. In some embodiments, the semiconductor die 402A and 402B may be configured in a side-by-side arrangement as an alternative to the stacked semiconductor die 402A-B. In some embodiments, at least one of the semiconductor die 402A and 402B may be configured in a flip-chip arrangement.

In this embodiment, the upper leadframe 102 populated with mounted semiconductor die 202A and 202B and the lower leadframe 302 populated with mounted semiconductor die 402A and 402B are joined together by way of the non-conductive adhesive material 502 in a backside-to-backside arrangement. Portions of the leadframes 102 and 302 joined together along with respective semiconductor die 202A-B and 402A-B are encapsulated with the encapsulant 602. After encapsulation, exposed portions of the leads 104 and 304 of the semiconductor device 800 are subjected to a trim and form operation in which the leads 104 and 304 are singulated from respective leadframes 102 and 302 and mechanically shaped (e.g., bent).

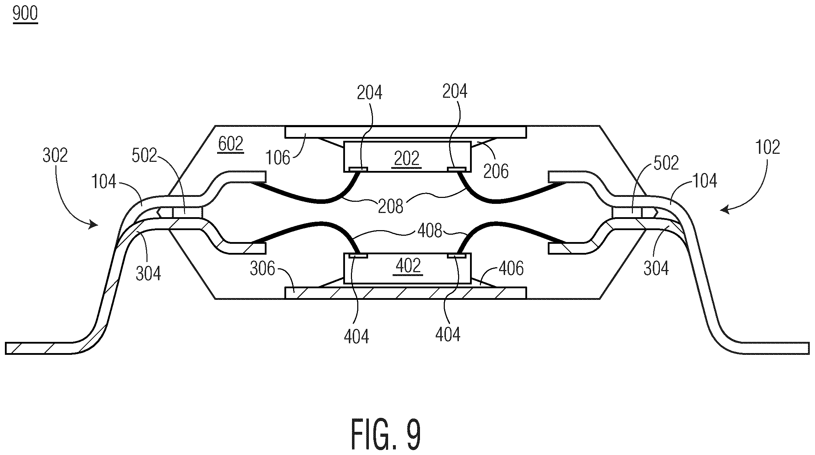

FIG. 9 illustrates, in a simplified cross-sectional view, another alternative example semiconductor device 900 at a stage of manufacture in accordance with an embodiment. In this embodiment, semiconductor die 202 and 402 are attached to respective downset die pads 106 and 306, wire bonded to respective leads 104 and 304 and encapsulated with the encapsulant 602.

As an alternative to the coplanar die pad 106 and leadframe leads 104 of the leadframe 102 depicted in FIG. 2, the leadframe 102 depicted in FIG. 9 is configured with a downset die pad 106. The semiconductor die 202 is attached to the downset die pad 106 by way of the die attach material 206. Bond pads 204 of the semiconductor die 202 are connected to respective leadframe leads 104 by way of the bond wires 208. Likewise, as an alternative to the coplanar die pad 306 and leadframe leads 304 of the leadframe 302 depicted in FIG. 4, the leadframe 302 depicted in FIG. 9 is configured with a downset die pad 306. The semiconductor die 402 is attached to the downset die pad 306 by way of the die attach material 406. Bond pads 404 of the semiconductor die 402 are connected to respective leadframe leads 304 by way of the bond wires 408.

In this embodiment, the upper leadframe 102 populated with mounted semiconductor die 202 and the lower leadframe 302 populated with mounted semiconductor die 402 are joined together by way of the non-conductive adhesive material 502 in an exposed die pad backside arrangement. Portions of the leadframes 102 and 302 joined together along with respective semiconductor die 202 and 402 are encapsulated with the encapsulant 602. After encapsulation, exposed portions of the leads 104 and 304 of the semiconductor device 900 are subjected to a trim and form operation in which the leads 104 and 304 are singulated from respective leadframes 102 and 302 and mechanically shaped (e.g., bent). In this embodiment, the backside surface of each of the die pads 106 and 306 is exposed through the encapsulant. The exposed backsides of the die pads 106 and 306 may be configured for attachment of a heatsink or heat spreader to facilitate heat dissipation, for example.

FIG. 10 illustrates, in a simplified plan view, an example portion of the semiconductor device 100 with dual leadframes at a stage of manufacture in accordance with an embodiment. At this stage, the semiconductor device 100 includes the leadframe 102 populated with mounted semiconductor die 202 and the leadframe 302 populated with mounted semiconductor die 402 joined together, encapsulated with the encapsulant 602, and exposed portions of the leadframe leads 104 and 304 trimmed and formed as depicted in FIG. 7. In this embodiment, the resulting lead pattern is an alternating or interleaved-like arrangement. For example, the exposed leads 304 of leadframe 302, depicted with a diagonal hatch fill-pattern, alternate with the exposed leads 104 of the leadframe 102 around the perimeter of the semiconductor device 100. By forming an alternating lead pattern in this manner, a finer lead pitch is achieved by joining two leadframes having coarser lead pitch.

Generally, there is provided, a method including attaching a first semiconductor die to a first die pad of a first leadframe; attaching a second semiconductor die to a second die pad of a second leadframe; attaching the first leadframe to the second leadframe by way of a non-conductive adhesive such that leads of a first plurality of leads of the first leadframe are interleaved with leads of a second plurality of leads of the second leadframe; and encapsulating with an encapsulant the first and second semiconductor die and portions of the first and second leadframes. The method may further include before encapsulating with the encapsulant: attaching a first end of a first bond wire to a first bond pad of the first semiconductor die and a second end of the first bond wire to a first lead of the first plurality of leads; and attaching a first end of a second bond wire to a second bond pad of the second semiconductor die and a second end of the second bond wire to a second lead of the second plurality of leads. The first lead of the first plurality of leads and the second lead of the second plurality of leads may be electrically isolated from one another. The attaching the first leadframe to the second leadframe by way of the non-conductive adhesive may include attaching a portion of the first plurality of leads of the first leadframe to a portion of the second plurality of leads of the second leadframe by way of the non-conductive adhesive. The attaching the first leadframe to the second leadframe by way of the non-conductive adhesive may further include attaching a backside of the first die pad of the first leadframe to a backside of the second die pad of the second leadframe by way of the non-conductive adhesive. The non-conductive adhesive may be characterized as a non-conductive die attach film (DAF). After encapsulating with the encapsulant, a backside of the first die pad of the first leadframe may be exposed through the encapsulant. The method may further include before encapsulating with the encapsulant, attaching a third semiconductor die to an active side of the first semiconductor die. The method may further include before encapsulating with the encapsulant, attaching a first end of a third bond wire to a first bond pad of the third semiconductor die and a second end of the third bond wire to a third lead of the first plurality of leads.

In another embodiment, there is provided, a semiconductor device including a first leadframe including a first die pad and a first plurality of leads; a first semiconductor die attached to the first die pad of the first leadframe; a second leadframe including a second die pad and a second plurality of leads, the first leadframe attached to the second leadframe by way of a non-conductive adhesive such that leads of the first plurality of leads are interleaved with leads of the second plurality of leads; a second semiconductor die attached to the second die pad of the second leadframe; and an encapsulant encapsulating the first and second semiconductor die and portions of the first and second leadframes. The semiconductor device may further include: a first bond wire having a first end attached to a first bond pad of the first semiconductor die and a second end attached to a first lead of the first plurality of leads; and a second bond wire having a first end attached to a second bond pad of the second semiconductor die and a second end attached to a second lead of the second plurality of leads. The first lead of the first plurality of leads and the second lead of the second plurality of leads may be electrically isolated from one another. The non-conductive adhesive may be disposed between a portion of the first plurality of leads of the first leadframe and a portion of the second plurality of leads of the second leadframe. The non-conductive adhesive may be disposed between a backside of the first die pad of the first leadframe and a backside of the second die pad of the second leadframe. The first plurality of leads of the first leadframe and the second plurality of leads of the second leadframe may be electrically isolated from one another.

In yet another embodiment, there is provided, a method including attaching a first semiconductor die to a first die pad of a first leadframe; attaching a second semiconductor die to a second die pad of a second leadframe; attaching a portion of a first plurality of leads of the first leadframe to a portion of a second plurality of leads of the second leadframe by way of a non-conductive adhesive, leads of the first plurality of leads interleaved with leads of the second plurality of leads; and encapsulating with an encapsulant the first and second semiconductor die, portions of the first and second leadframes, and the non-conductive adhesive. The method may further include before encapsulating with the encapsulant: attaching a first end of a first bond wire to a first bond pad of the first semiconductor die and a second end of the first bond wire to a first lead of the first plurality of leads; and attaching a first end of a second bond wire to a second bond pad of the second semiconductor die and a second end of the second bond wire to a second lead of the second plurality of leads. The first lead of the first plurality of leads and the second lead of the second plurality of leads may be electrically isolated from one another. The method may further include attaching a backside of the first die pad of the first leadframe to a backside of the second die pad of the second leadframe by way of the non-conductive adhesive. The method may further include exposing a backside of the first die pad of the first leadframe through a first major surface of the encapsulant.

By now it should be appreciated that there has been provided, a semiconductor device having dual leadframes. The semiconductor device includes a first semiconductor die mounted on a die pad of a first package leadframe having a first plurality of conductive leads and a second semiconductor die mounted on a die pad of a second package leadframe having a second plurality of conductive leads. The first package leadframe and the second package leadframe are joined together by way of an adhesive. Portions of the first and second package leadframes along with respective first and second semiconductor die are encapsulated with an encapsulant. Exposed portions of the first plurality of conductive leads and the second plurality of conductive leads are trimmed and formed in a desire shape. The resulting exposed lead pattern around the perimeter of the semiconductor device is an alternating or interleaved-like arrangement where the exposed leads of the first plurality of conductive leads are interleaved with the exposed leads of the second plurality of conductive leads. By forming the semiconductor device with an interleaved lead pattern in this manner, a cost effective, higher lead density with a finer lead pitch is achieved through joining two lower cost leadframes having coarser lead pitches.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method comprising:
attaching a first semiconductor die to a first die pad of a first leadframe;
attaching a second semiconductor die to a second die pad of a second leadframe;
attaching the first leadframe to the second leadframe by way of a non-conductive adhesive such that leads of a first plurality of leads of the first leadframe are interleaved with leads of a second plurality of leads of the second leadframe; and
encapsulating with an encapsulant the first and second semiconductor die and portions of the first and second leadframes.

2. The method of claim 1, further comprising before encapsulating with the encapsulant:
attaching a first end of a first bond wire to a first bond pad of the first semiconductor die and a second end of the first bond wire to a first lead of the first plurality of leads; and
attaching a first end of a second bond wire to a second bond pad of the second semiconductor die and a second end of the second bond wire to a second lead of the second plurality of leads.

3. The method of claim 2, wherein the first lead of the first plurality of leads and the second lead of the second plurality of leads are electrically isolated from one another.

4. The method of claim 1, wherein attaching the first leadframe to the second leadframe by way of the non-conductive adhesive includes attaching a portion of the first plurality of leads of the first leadframe to a portion of the second plurality of leads of the second leadframe by way of the non-conductive adhesive.

5. The method of claim 4, wherein attaching the first leadframe to the second leadframe by way of the non-conductive adhesive further includes attaching a backside of the first die pad of the first leadframe to a backside of the second die pad of the second leadframe by way of the non-conductive adhesive.

6. The method of claim 1, wherein the non-conductive adhesive is characterized as a non-conductive die attach film, DAF.

7. The method of claim 1, wherein after encapsulating with the encapsulant a backside of the first die pad of the first leadframe is exposed through the encapsulant.

8. The method of claim 1, further comprising before encapsulating with the encapsulant, attaching a third semiconductor die to an active side of the first semiconductor die.

9. The method of claim 8, further comprising before encapsulating with the encapsulant, attaching a first end of a third bond wire to a first bond pad of the third semiconductor die and a second end of the third bond wire to a third lead of the first plurality of leads.

10. A semiconductor device comprising:
a first leadframe including a first die pad and a first plurality of leads;
a first semiconductor die attached to the first die pad of the first leadframe;
a second leadframe including a second die pad and a second plurality of leads, the first leadframe attached to the second leadframe by way of a non-conductive adhesive such that leads of the first plurality of leads are interleaved with leads of the second plurality of leads;
a second semiconductor die attached to the second die pad of the second leadframe; and
an encapsulant encapsulating the first and second semiconductor die and portions of the first and second leadframes.

11. The semiconductor device of claim 10, further comprising:
a first bond wire having a first end attached to a first bond pad of the first semiconductor die and a second end attached to a first lead of the first plurality of leads; and
a second bond wire having a first end attached to a second bond pad of the second semiconductor die and a second end attached to a second lead of the second plurality of leads.

12. The semiconductor device of claim 11, wherein the first lead of the first plurality of leads and the second lead of the second plurality of leads are electrically isolated from one another.

13. The semiconductor device of claim 10, wherein the non-conductive adhesive is disposed between a portion of the first plurality of leads of the first leadframe and a portion of the second plurality of leads of the second leadframe.

14. The semiconductor device of claim 10, wherein the non-conductive adhesive is further disposed between a backside of the first die pad of the first leadframe and a backside of the second die pad of the second leadframe.

15. The semiconductor device of claim 10, wherein the first plurality of leads of the first leadframe and the second plurality of leads of the second leadframe are electrically isolated from one another.
